# FASCICULE DE BREVET EUROPEEN

(11) **EP 0 837 545 B1**
(45) Date de publication et mention de la délivrance du brevet: **25.07.2001**
(21) Numéro de dépôt: 97410115.6
(22) Date de dépôt: 15.10.1997
(51) Int. Cl.: H02M 1/08, H03K 17/13

(54) **Circuit de commande au zéro de tension d'un triac**
Nullspannungssteuerschaltung für einen Triac
Zero voltage control circuit for a triac

(30) Priorité: 16.10.1996 FR 9612785
(43) Date de publication de la demande: 22.04.1998
(73) Titulaire: STMicroelectronics S.A., 94250 Gentilly (FR)
(72) Inventeur: Rault, Pierre, 37540 Saint Cyr Sur Loire (FR)
(74) Mandataire: de Beaumont, Michel

(56) Documents cités:
- DE-A- 2 559 564
- US-A- 3 902 080
- US-A- 4 258 276
- US-A- 4 645 982

## Description

La présente invention concerne le domaine de la commande de composants de forte ou moyenne puissance du type triac.

Un triac est un composant de commutation qui correspond à l'association en anti-parallèle de deux thyristors. Il est donc susceptible de bloquer ou de laisser passer des tensions de l'une ou l'autre polarité, c'est-à-dire qu'il peut être connecté directement dans un réseau alternatif, par exemple le secteur.

Un triac comprend deux bornes principales A1 et A2, et une borne de commande, couramment appelée gâchette. Un triac est susceptible d'entrer en conduction quand un potentiel positif ou négatif existe entre ses bornes A1 et A2 et qu'une impulsion de courant négative ou positive est amenée à circuler entre la borne de gâchette et la borne A1 que l'on appellera borne de référence ou borne principale associée à la gâchette. Le triac reste ensuite conducteur jusqu'à ce que le courant qui le traverse passe par zéro.

Il est connu que, quand on veut commander un triac à la conduction pendant une durée longue devant la période du secteur, il est intéressant de déclencher la mise en conduction au moment où la tension aux bornes du triac est proche de zéro. On appelle ce type de commande une commande au zéro de tension bien que, en fait, elle se produise alors que la tension aux bornes du triac est suffisante pour permettre sa mise en conduction, par exemple voisine de l'ordre de quelques volts.

Ce type de commande présente l'avantage de réduire les contraintes de courant à la commutation et de réduire le renvoi de parasites et d'harmoniques sur le secteur. Il en résulte une augmentation de la fiabilité du triac. En outre, ce type de commande est maintenant imposé par diverses normes.

Plusieurs circuits connus réalisent cette fonction. Toutefois, ces circuits présentent au moins l'un des inconvénients suivants. Ils sont complexes, nécessitent un grand nombre de composants dont certains ne sont pas intégrables, par exemple des condensateurs de forte valeur, et/ou consomment une puissance non-négligeable.

Les brevets américains 3902080 et 4258276 décrivent des circuits de commutation au zéro de tension d'un triac dans lesquels le courant de gâchette du triac provient du réseau. Ces circuits présentent l'inconvénient de consommer de la puissance au repos et de produire du bruit sur le réseau à chaque commutation à la fermeture du triac.

Ainsi, l'objet de la présente invention est de prévoir un circuit de commande au zéro de tension d'un triac qui évite les inconvénients des circuits connus.

Notamment, la présente invention vise à réaliser un tel circuit comprenant un petit nombre de composants, tous ces composants étant intégrables, ce circuit présentant en outre une faible consommation.

Pour atteindre ces objets, la présente invention prévoit un circuit de commande au zéro de tension d'un triac, comprenant deux transistors de types complémentaires connectés en parallèle entre la gâchette et la borne principale de référence du triac, les bornes de commande des transistors étant interconnectées et reliées à la deuxième borne principale du triac par l'intermédiaire d'une résistance de forte valeur, et la gâchette du triac étant reliée à une source de potentiel continu de commande par l'intermédiaire d'une deuxième résistance.

Selon un mode de réalisation de la présente invention, la tension de la source de potentiel de commande est commutable entre la valeur de la tension de la borne de référence et une valeur négative par rapport à la tension de la borne de référence.

Selon un mode de réalisation de la présente invention, les transistors complémentaires sont des transistors bipolaires NPN et PNP.

Selon un mode de réalisation de la présente invention, les transistors complémentaires sont des transistors MOS à canal N et P.

Selon un mode de réalisation de la présente invention, une diode à avalanche bidirectionnelle est connectée entre la grille des transistors MOS et la borne de référence.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un premier mode de réalisation d'un circuit de commande au zéro de tension d'un triac selon la présente invention ; et
la figure 2 représente un deuxième mode de réalisation d'un circuit de commande au zéro de tension d'un triac selon la présente invention.

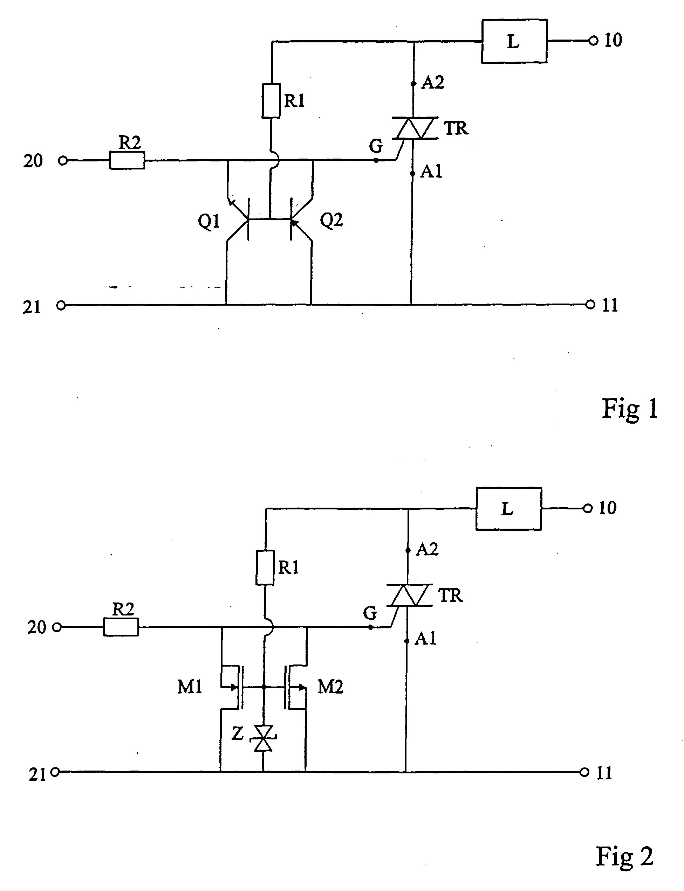

La figure 1 représente un triac TR relié par une borne principale A2 à une charge L, la connexion en série de la charge L et du triac TR étant connectée entre des bornes de tension alternative 10, 11, par exemple le secteur. La borne 11 est à un potentiel de référence, par exemple la masse et est reliée à la borne principale A1 ou borne de référence du triac.

Selon la présente invention, deux transistors complémentaires sont connectés entre la borne de gâchette G et la borne de référence A1 du triac. Dans l'exemple de la figure 1, ces transistors complémentaires sont un transistor bipolaire de type NPN Q1 et un transistor bipolaire de type PNP Q2. L'émetteur du transistor Q1 et le collecteur du transistor Q2 sont reliés à la gâchette G. Le collecteur du transistor Q1 et l'émetteur du transistor Q2 sont reliés à la borne A1 du triac. Les bases des transistors Q1 et Q2 sont reliées l'une à l'autre et à la borne A2 par l'intermédiaire d'une résistance de forte valeur R1. L'ordre de commande est appliqué entre des bornes 20 et 21. La borne 21 est reliée à la borne 11 et constitue une borne de référence. La borne 20 est reliée à la gâchette G par l'intermédiaire d'une résistance R2. L'ordre de commande est un signal ayant une valeur de 0 volt (le potentiel des bornes 11 et 21) quand on ne souhaite pas que le triac soit mis en conduction et une valeur négative, par exemple -5 volts, quand on souhaite commander le triac en conduction.

Le fonctionnement de ce circuit est le suivant.

Quand la tension sur la borne 10 est élevée, l'un ou l'autre des transistors Q1 ou Q2 est commandé à l'état passant. Les bornes G et A1 sont alors court-circuités par l'un ou l'autre des transistors et aucun courant de commande ne peut circuler entre les bornes G et A1.

Quand la tension sur la borne 10 est inférieure à un certain seuil, qui dépend notamment de la valeur de la résistance R1 et du gain des transistors, et qui peut être de l'ordre de 10 volts, les deux transistors Q1 et Q2 sont bloqués et, si la tension sur la borne de commande 20 est négative, un courant circulera de la borne A1 à la borne G et entraînera la mise en conduction du triac. Ainsi, on peut considérer que l'application d'un ordre de commande (potentiel négatif) sur la borne 20 est retardée jusqu'à ce que le potentiel sur la borne A2 ait chuté à une valeur faible par rapport au potentiel sur la borne A1. Il s'agit donc bien d'une commande au zéro de tension.

Ensuite, de façon classique, le triac TR s'ouvrira chaque fois que la tension à ses bornes chute et devient voisine d'une valeur nulle. Le triac sera ensuite remis en conduction au début de l'alternance suivante (positive ou négative) si l'ordre de commande est toujours présent.

On a indiqué précédemment que l'ordre de commande était fourni sous la forme d'une tension négative par rapport à la tension de référence et les transistors Q1 et Q2 ont été connectés en conséquence. Si l'ordre de commande était fourni sous forme d'une impulsion positive, les connexions de collecteur et d'émetteur de chacun des transistors Q1 et Q2 devraient être inversées. Toutefois, on préférera les polarités illustrées dont la figure et décrites précédemment car, comme cela est connu, on a généralement une meilleure symétrie de mise en conduction d'un triac quand on opère avec les polarités indiquées, c'est-à-dire dans les deuxième et troisième quadrants, plutôt que quand on opère dans les premier et quatrième quadrants, ce qui se produirait si la tension de commande était positive. En effet, les déclenchements dans le quatrième quadrant sont généralement peu sensibles dans le cas de la plupart des triacs existants.

Dans un mode de réalisation pratique, on pourra choisir la résistance R1 d'une valeur de 120 kilohms et la résistance R2 d'une valeur de 330 ohms. Ces valeurs sont données uniquement à titre indicatif, la résistance R1 devant avoir une valeur élevée pour limiter la consommation du circuit de commande et la résistance R2 une valeur propre à optimiser le courant de gâchette du triac. Si R1 = 120 kilohms et que la tension aux bornes 10, 11 est la tension du secteur à 220 volts efficace, le courant moyen dans la résistance R1 sera de 2 milliampères et la consommation du circuit de l'ordre de 0,4 watts.

La figure 2 représente un exemple de variante de l'invention. Le circuit est identique à celui de la figure 1 sauf que les transistors bipolaires complémentaires Q1 et Q2 sont remplacés par des transistors MOS à enrichissement complémentaires M1 et M2, respectivement à canal N et à canal P. Dans ce mode de réalisation, pour éviter qu'une tension de grille importante apparaisse sur les transistors M1 et M2, on prévoit de préférence une liaison des grilles des transistors MOS à la tension de référence par l'intermédiaire d'une double diode à avalanche Z qui devient conductrice quand la tension sur la grille dépasse un seuil (positif ou négatif) déterminé, par exemple 20 volts. Par ailleurs, le fonctionnement du circuit de la figure 2 est similaire à celui de la figure 1.

L'homme de l'art notera que la présente invention est susceptible de diverses variantes et modifications. Notamment, les figures 1 et 2 représentent des exemples de réalisation de la présente invention sous forme de composants discrets. Il sera clair que l'ensemble du triac et des transistors complémentaires associés peut être réalisé de façon monolithique. Par ailleurs, ces transistors complémentaires seront simples à réaliser puisqu'ils ne voient entre leurs bornes principales qu'une faible tension. Les résistances R1 et R2 pourront également être intégrées en notant toutefois que la résistance R1 doit être en une technologie haute tension puisqu'elle est amenée à supporter la tension du secteur.

Le triac décrit précédemment peut également être un triac de moyenne puissance, de commande d'un triac ou autre commutateur de forte puissance.

## Revendications

1. Circuit de commande au zéro de tension d'un triac, comprenant deux transistors de types complémentaires (Q1, Q2 ; M1, M2) connectés en parallèle entre la gâchette (G) et la borne principale de référence (A1) du triac (TR), les bornes de commande des transistors étant interconnectées et reliées à la deuxième borne principale (A2) du triac par l'intermédiaire d'une résistance (R1) de forte valeur, caractérisé en ce que la gâchette (G) du triac est reliée à une source de potentiel continu de commande par l'intermédiaire d'une deuxième résistance (R2).

2. Circuit de commande selon la revendication 1, caractérisé en ce que la tension de la source de potentiel de commande est commutable entre la valeur de la tension de ladite borne de référence et une valeur négative par rapport à la tension de ladite borne de référence.

3. Circuit de commande selon la revendication 1 ou 2, caractérisé en ce que les transistors complémentaires sont des transistors bipolaires NPN et PNP (Q1, Q2).

4. Circuit de commande selon la revendication 1 ou 2, caractérisé en ce que les transistors complémentaires sont des transistors MOS à canal N et P (M1, M2).

5. Circuit de commande selon la revendication 4, caractérisé en ce qu'une diode à avalanche bidirectionnelle est connectée entre la grille des transistors MOS (M1, M2) et ladite borne de référence.

## Claims

1. A circuit for controlling a triac at the voltage zero, including two transistors of complementary types (Q1, Q2; M1, M2) connected in parallel between the gate (G) and the main reference terminal (A1) of the triac (TR), the control terminals of the transistors being interconnected and connected to the second main terminal (A2) of the triac via a resistor (R1) of high value, characterized in that the triac gate (G) is connected to a d.c. potential control source via a second resistor (R2).

2. A control circuit according to claim 1, characterized in that the voltage of the control potential source is switchable between the value of the voltage of the reference terminal and a negative value with respect to the voltage of the reference terminal.

3. A control circuit according to claim 1 or 2, characterized in that the complementary transistors are NPN and PNP bipolar transistors (Q1, Q2).

4. A control circuit according to claim 1 or 2, characterized in that the complementary transistors are N- and P-channel MOS transistors (M1, M2).

5. A control circuit according to claim 4, characterized in that a bidirectional avalanche diode is connected between the gate of the MOS transistors (M1, M2) and the reference terminal.

## Patentansprüche

1. Schaltung zur Umschaltsteuerung eines Triacs bei Spannung Null, mit zwei Transistoren komplementären Typs (Q1, Q2; M1, M2), die parallel zueinander zwischen dem Gate (G) und dem Bezugs-Hauptanschluß (A1) des Triacs (TR) liegen, wobei die Steueranschlüsse der Transistoren miteinander und mit dem zweiten Hauptanschluß (A2) des Triac (TR) über einen Widerstand (R1) großen Betrags verbunden sind,
**dadurch gekennzeichnet**, daß das Gate (G) des Triac (TR) über einen zweiten Widerstand (R2) mit einer Quelle eines Steuer-Gleichspannungspotentials verbunden ist.

2. Steuerschaltung nach Anspruch 1, dadurch gekennzeichnet, daß die Spannung der Steuerpotentialquelle zwischen dem Betrag der Spannung des genannten Bezugsanschlusses und einem bezüglich der Spannung des genannten Bezugs-Anschlusses negativen Wert umschaltbar ist.

3. Steuerschaltung nach Anspruch 1 oder 2, dadurch gekennzeichnet, daß die komplementären Transistoren NPN- und PNP- Bipolartransistoren (Q1,Q2) sind.

4. Steuerschaltung nach Anspruch 1 oder 2, dadurch gekennzeichnet, daß die komplementären Transistoren N-Kanal-und P-Kanal- MOS-Transistoren (M1,M2) sind.

5. Steuerschaltung nach Anspruch 4, dadurch gekennzeichnet, daß zwischen dem Gitter der MOS-Transistoren (M1,M2) und dem genannten Bezugsanschluß eine bidirektionale Lawinendurchbruch- bzw. Zenerdiode (Z) vorgesehen ist.
